# EUROPEAN PATENT SPECIFICATION

(11) **EP 4 047 713 B1**
(45) Date of publication and mention of the grant of the patent: **11.11.2026**
(21) Application number: 21158086.5
(22) Date of filing: 19.02.2021
(51) Int. Cl.: H01M 10/42, B60L 50/64, H01M 10/48, H01M 50/249, H01M 50/284, H01M 50/50, H01M 50/569, H01M 50/572, H01R 13/66, G01R 31/364, B60L 58/25

(54) **THERMAL PROTECTION OF CONNECTOR**
THERMISCHER SCHUTZ FÜR EINEN VERBINDER
PROTECTION THERMIQUE DE CONNECTEUR

(43) Date of publication of application: 24.08.2022
(73) Proprietor: Samsung SDI Co., Ltd., Yongin-si, Gyeonggi-do 17084 (KR)
(72) Inventor: Haindl, Michael, 8230 Hartberg (AT); Haring, Fritz, 8600 Bruck / Mur (AT)
(74) Representative: Gulde & Partner

(56) References cited:
- EP-A1- 3 683 087
- US-A1- 2011 298 472
- US-A1- 2014 268 473
- US-A1- 2019 319 317

## Description

### Field of the Invention

The present invention relates to connector system for establishing an electric connection with a battery system, and in particular to a connector system, wherein the connection elements are protected against thermal overload. The invention further relates to a battery system comprising the connector system according to the invention. Also, the invention relates to a battery module comprising several of those battery systems. Further, the invention refers to a vehicle employing the battery system or the battery module according to the invention. Moreover, the invention relates to a method for controlling an electrically conductive connection to a battery system using the connector system according to the invention.

### Technological Background

In the recent years, vehicles for transportation of goods and peoples have been developed using electric power as a source for motion. Such an electric vehicle is an automobile that is propelled by an electric motor, using energy stored in rechargeable batteries. An electric vehicle may be solely powered by batteries or may be a form of hybrid vehicle additionally powered by for example a gasoline generator. Furthermore, the vehicle may include a combination of electric motor and conventional combustion engine. In general, an electric-vehicle battery (EVB) or traction battery is a battery used to power the propulsion of battery electric vehicles (BEVs). Electric-vehicle batteries differ from starting, lighting, and ignition batteries because they are designed to give power over sustained periods of time. A rechargeable or secondary battery differs from a primary battery in that it can be repeatedly charged and discharged, while the latter provides only an irreversible conversion of chemical to electrical energy. Low-capacity rechargeable batteries are used as power supply for small electronic devices, such as cellular phones, notebook computers and camcorders, while high-capacity rechargeable batteries are used as the power supply for hybrid vehicles and the like.

In general, rechargeable batteries include an electrode assembly including a positive electrode, a negative electrode, and a separator interposed between the positive and negative electrodes, a case receiving the electrode assembly, and an electrode terminal electrically connected to the electrode assembly. An electrolyte solution is injected into the case in order to enable charging and discharging of the battery via an electrochemical reaction of the positive electrode, the negative electrode, and the electrolyte solution. The shape of the case, e.g. cylindrical or rectangular, depends on the battery's intended purpose. Lithium-ion (and similar lithium polymer) batteries, widely known via their use in laptops and consumer electronics, dominate the most recent group of electric vehicles in development.

Rechargeable batteries may be used as a battery module formed of a plurality of unit battery cells coupled in series and/or in parallel so as to provide a high energy density, in particular for motor driving of a hybrid vehicle. That is, the battery module is formed by interconnecting the electrode terminals of the plurality of unit battery cells depending on a required amount of power and in order to realize a high-power rechargeable battery.

A battery pack is a set of any number of (preferably identical) battery modules. They may be configured in a series, parallel or a mixture of both to deliver the desired voltage, capacity, or power density. Components of battery packs include the individual battery modules, and the interconnects, which provide electrical conductivity between them.

For meeting the dynamic power demands of various electrical consumers connected to the battery system a static control of battery power output and charging is not sufficient. Thus, steady exchange of information between the battery system and the controllers of the electrical consumers is required. This information includes the battery systems actual state of charge (SoC), potential electrical performance, charging ability and internal resistance as well as actual or predicted power demands or surpluses of the consumers.

Battery systems usually comprise a battery management system (BMS) and/or battery management unit (BMU) for processing the aforementioned information. The BMS/BMU may communicate to the controllers of the various electrical consumers via a suitable communication bus, e. g. a SPI or CAN interface. The BMS/BMU may further communicate with each of the battery submodules, particularly with a cell supervision circuit (CSC) of each battery submodule. The CSC may be further connected to a cell connection and sensing unit (CCU) of a battery submodule that interconnects the battery cells of the battery submodule.

Thus, the BMS/BMU is provided for managing the battery pack, such as by protecting the battery from operating outside its safe operating area, monitoring its state, calculating secondary data, reporting that data, controlling its environment, authenticating it and/or balancing it.

To establish an electric connection between the battery of a vehicle and a load powered by the battery, a connector or connector system is required. The lifetime of the connector or connector system depends essentially on the temperature, to which the connector or connector system is exposed during use. If a maximum temperature is exceeded, the connector or connector system may be destroyed. The temperature, to which the connector or connector system is heated up, depends in turn essentially on the current being conducted through the connector or connector system. Thus, respective protection mechanisms are employed to prevent the connector or connector system from being heated up over a certain maximum temperature, which has to be determined in advance, i. e., during the design process of the connector or connector system. For example, US 2011/298472 A1 provides a battery-connection-failure detection system that monitors the temperature of a cell body and its electrical connectors (or between connectors) together with current flow. A software-driven comparator calculates the temperature difference, compares it with a predetermined safe difference (current-dependent or independent), and triggers an alarm when the limit is exceeded. Various sensor types (thermocouples, resistance transducers, etc.) and configurations (single- or dual-connector monitoring) are disclosed.

Currently the connectors are protected using a fuse or by monitoring the current conducted through the connector.

When using a fuse, the tolerances of the connector and the fuse need to be considered, ensuring that no reaction of the fuse occurs for electrical currents within the normal use (i. e., within a certain predefined current range), but guaranteeing for a blowing of the fuse in case of an overload of the connector. Hence, an oversizing of the connector based on the tolerances and estimation of relevant environment is required to ensure that the connector temperature keeps in a specified range.

When monitoring the current, an additional current measurement needs to be employed, which increases the cost. The real overload of the connector is estimated including all possible tolerances (e. g., boundary temperature, inner resistance, etc.). Again, an oversizing of the connector based on the tolerances and estimation of relevant environment is required to ensure that the connector temperature keeps in a specified range.

It is thus an object of the present invention to overcome or reduce at least some of the drawbacks of the prior art and to provide a connector system as well as battery system comprising this connector system, wherein the consideration of tolerances and thus an oversizing of components can be avoided. It is also an object of the present invention to provide a method for controlling an electrically conductive connection to a battery system using the connector system according to the invention.

### Summary of Invention

Embodiments of the present disclosure seek to solve at least one of the problems existing in the prior art to at least some extent. In particular, a connector system for establishing an electric connection with a battery system is provided, the connector system comprising: a connector for establishing an electrically conductive connection to a suitable counterpart of the connector, wherein the connector comprises a negative connection element and a positive connection element; a first temperature sensor thermally connected to the negative connection element; a second temperature sensor thermally connected to the positive connection element; and a control unit configured for receiving a first temperature signal from the first temperature sensor and for receiving a second temperature signal from the second temperature sensor. The control unit is adapted for generating a first value based on the first temperature signal and a second value based on the second temperature signal. The control unit is further adapted for generating a first alert signal when the absolute value of a difference between the first value and the second value exceeds over a predefined threshold. The negative connection element is electrically connected with an anode of a stack of battery cells of the battery system via a first electrical connection line, and the positive connection element is electrically connected with a cathode of the stack of battery cells via a second electrical connection line. The control unit is further configured to output a second alert signal based on at least one of the first value and the second value. The second alert signal is a signal suitable for directly controlling a relay implemented into one of the first electrical connection line and the second electrical connection line.

By measuring the temperature of the connection elements directly, a high accurate protection is possible, and the connector can be minimized to the required normal current without high impact of unknown environmental conditions.

The temperature signals may depend monotonously (or strictly monotonously) on the respective measured temperature. In other words, the temperature signals may be a monotonic (or strictly monotonic) function of the measured temperature.

If the absolute value of the difference between the first value and the second value exceeds over a predefined threshold, the probability that a contact resistance between one of the connection elements and its respective counterpart connection element (the latter not being part of the invention) is increased, which in turn may indicate a connection failure.

The decision whether or not, an alert signal is generated is based on the absolute value of the difference between the first value and the second value and thus independent of the algebraic sign of said difference. However, the signal itself (i. e., the kind of signal) may be depending on the algebraic sign of the difference; in this case, the signal may yield an indication, which of the two connection elements may be affected by a connection failure.

The alert signal itself may be an electric signal provided at an output of the control unit. Alternatively, the alert signal may be proved wirelessly, e. g., via an NFC signal or a WLAN signal or the like.

Instead of "negative connection element," also the term "first connection element" could be used. Correspondingly, it could be used the expression "second connection element" instead of "positive connection element." In this context, the terms "negative connection element" and "positive connection element" have simply been used to make clear that the "negative connection element" may be adapted to be connected to an anode of a battery (or stack of battery cells), and that the "positive connection element" may be adapted to be connected to a cathode of a battery (or stack of battery cells). Usually, however, any one of the connection elements could be used to establish a connection to the anode, and the other one to establish a connection with the cathode of a battery or stack of battery cells.

In one embodiment of the connector system according to the invention, the predefined threshold depends on the first temperature signal or on the second temperature signal or on a mean value of the first and second temperature signal.

The higher the voltages, the larger may be the tolerances in the absolute difference between the temperature of the negative connection element and the positive connection element. To take this into account, a kind of relative temperature difference may be used. To that end, the difference between the absolute temperature values may be divided by the temperature values of the negative connection element or by that of the positive connection element or by a mean value (e. g., the arithmetic mean) of the temperature values of the negative and positive connection elements.

In one embodiment of the connector system according to the invention, the connector is formed as a socket being connectable with a suitable plug.

In one embodiment of the connector system according to the invention, the connector is formed as a plug being connectable with a suitable socket.

In one embodiment of the connector system according to the invention, the negative connection element and the positive connection element are each configured for establishing a high voltage (HV) connection.

In one embodiment of the connector system according to the invention, at least one of the temperature sensors is a thermistor, for example a negative temperature coefficient (NTC) thermistor or a positive coefficient temperature (PTC) thermistor, or a thermocouple.

In one embodiment of the connector system according to the invention, the control unit is further adapted for generating the second alert signal in case the first value or the second value indicates that the absolute temperature of the negative connection element or the positive connection element exceeds a predefined maximum value.

In one embodiment of the connector system according to the invention, the connector is integrated in a housing adapted for accommodating a stack of battery cells.

A further aspect of the invention is related to a battery system comprising a stack of battery cells and the connector system according to the invention (see above), wherein the stack of battery cells is accommodated in the housing, and wherein the negative connection element is electrically connected with the anode of the stack of battery cells and the positive connection element is electrically connected with the cathode of the stack of battery cells.

In one embodiment of the battery system, the battery system comprises a stack of battery cells and the connector system according to the invention, wherein the negative connection element is electrically connected with the anode of the stack of battery cells and the positive connection element is electrically connected with the cathode of the stack of battery cells.

In one embodiment of the battery system, the battery system further comprises a battery management unit, and wherein the control unit is integrated into the battery management unit.

A further aspect of the invention relates to a battery module comprising two or more battery systems according to the invention.

A further aspect of the invention relates to a vehicle comprising the battery system according to the invention or the battery module according to the invention.

A further aspect of the invention relates to a method for controlling an electrically conductive connection to a battery system using the connector system according to the invention. The method comprising the following steps:
- measuring, by a first temperature sensor, the temperature of a negative connection element and generating a first temperature signal based on the measured temperature of the negative connection element;
- sending the first temperature signal to a control unit;
- measuring, by a second temperature sensor, the temperature of a positive connection element and generating a second temperature signal based on the measured temperature of the positive connection element;
- sending the second temperature signal to the control unit;
- generating, by the control unit, a first value based on the first temperature signal and a second value based on the second temperature signal;
- computing, by the control unit, the difference of the first value and the second value;
   and
- generating, by the control unit, a first alert signal when the absolute value of said difference exceeds a predefined threshold.

The method further comprises outputting, by the control unit, a second alert signal based on at least one of the first value and the second value, wherein the negative connection element is electrically connected with an anode of a stack of battery cells of the battery system via a first electrical connection line, and the positive connection element is electrically connected with a cathode of the stack of battery cells via a second electrical connection line, and wherein the second alert signal is a signal suitable for directly controlling a relay implemented into one of the first electrical connection line and the second electrical connection line.

In one embodiment of the method, each of the steps is performed or repeated continuously in time.

In one embodiment of the method, each of the steps is repeated after a predefined time interval.

Further aspects of the present invention could be learned from the dependent claims or the following description. However, the invention is defined by the appended claims.

### Brief Description of the Drawings

Features will become apparent to those of ordinary skill in the art by describing in detail exemplary embodiments with reference to the attached drawings in which:
- Fig. 1: is an exemplary diagram used for designing connectors according to the state of the art;
- Fig. 2: shows a schematic illustration of a conventional connector system with a fuse, wherein the connector system is integrated in a battery system;
- Fig. 3: shows a schematic illustration of a conventional connector system with an amperemeter, wherein the connector system is integrated in a battery system;
- Fig. 4: shows a schematic illustration of a connector system according to an embodiment of the invention, wherein the connector system is integrated in a battery system; and
- Fig. 5: shows a schematic illustration of a connector system according to a further embodiment of the invention, wherein the connector system is integrated in a battery system.

### Detailed Description of the Invention

Reference will now be made in detail to embodiments, examples of which are illustrated in the accompanying drawings.

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present invention.

In the following description of embodiments of the present invention, the terms of a singular form may include plural forms unless the context clearly indicates otherwise.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

The electronic or electric devices and/or any other relevant devices or components according to embodiments of the present invention described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the exemplary embodiments of the present invention.

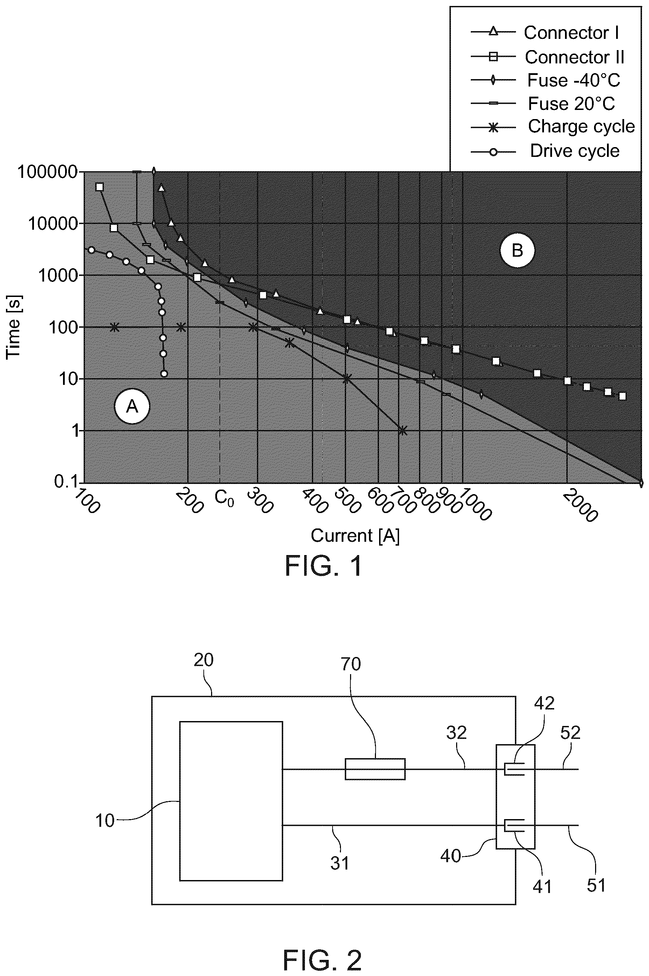

Figure 1 is an exemplary diagram used for designing a connector system according to the state of the art. Shown is the lifetime (in units of seconds [s] on a logarithmic scale) in dependence of the current (in units of Ampère [A] likewise on a logarithmic scale) of components of the conventional connector system such as the connector itself (connector I; see the legend of the diagram) and a fuse. A conventional connector system using a fuse is explained below in more detail. As the behavior of the fuse strongly depends on its temperature, it is plotted in the diagram for two different temperatures -40° C and +20° C (see the legend of the diagram).

The lines describing the behavior of the fuse can be interpreted as follows: These lines each specify (for the respective temperature, here: -40° C and +20° C), how many seconds it takes for the fuse to operate (i. e., to stop the current flow), if a certain current measured in Ampère flows through the fuse. As can be seen from the diagram of Fig. 1, the fuse operates more slowly for lower temperatures (the curve for the fuse at -40° C runs above the curve for the fuse at +20° C). Since a worst-case scenario has to be considered for designing a safety-critical connector system, the upper curve showing the behavior of the fuse at -40° C will be considered in the following. To facilitate the following description, the diagram is divided in two disjoint areas separated by the line illustrating the fuse's behavior at -40° C: Area A is the region in the diagram below this line, and area B denotes the region in the diagram above this line.

Also shown in the diagram of Fig. 1 is the lifetime of the battery cells under the conditions of fast charging the battery system and during the conditions of an exemplary drive cycle, i. e., during use in a vehicle (see the diagram's legend for the respective lines). Both, the line illustrating the fast charging and the line illustrating the exemplary drive cycle, run below the curves indicating the behavior of the fuse, i. e., these lines run completely in area A. This is necessary, as otherwise the fuse could operate and stop the flow of current in situations of a normal use of the battery system.

Further, the curve showing the lifetime of a connector in the diagram can be interpreted as follows: It specifies, how many seconds it takes for the connector to become destroyed, if a certain (over-)current measured in Ampère flows through the connector. Hence, the curve showing the lifetime of the connector of the conventional connector system with a fuse (i. e., the line of connector I; see the diagram's legend) runs above the lines indicating the behavior of the fuse, i. e., the curve of connector 1 runs completely in area B. Otherwise, i. e., in case the curve of connector I would touch or intersect the curve of the fuse, the conventional connector system would not be properly designed, as in this case, a situation could happen, wherein the connector becomes destroyed by an over-current, before the fuse would operate and stop the current. In other words, area B denotes the area being protected by the fuse (at a fuse's temperature of -40° C).

When designing the connector system, also the tolerances of its components have to be taken into account. Accordingly, there must be a minimum distance (in the vertical direction) between the curve of the fuse and the curve of the connector to assure that even if the connector is destroyed earlier as assumed (for a certain over-current) or if the fuse operates later than expected (for a certain over-current), the operation of the fuse still would occur earlier than the destruction of the connector. Further, as one typically does not know the boundary conditions for the specific application, the worst case has always to be considered. Based on these conditions, the connectors, fuses and/or current measurement equipment has to be selected for designing a conventional connector system.

As can be also taken from the diagram, the most critical effect on the lifetime of the connector system or a component thereof is caused by the temperature, which is in turn directly dependent on the current transported through the connector system. The larger the current transported through the connector system (and thus the higher the temperature of its components), the shorter the lifetime of the connector system and its components. This is reflected by the curves shown in the diagram, which are each descending when the current is increasing. Similar relations, of course, hold for the curves illustrating the lifetime of the battery cells for fast charging and use (drive cycle).

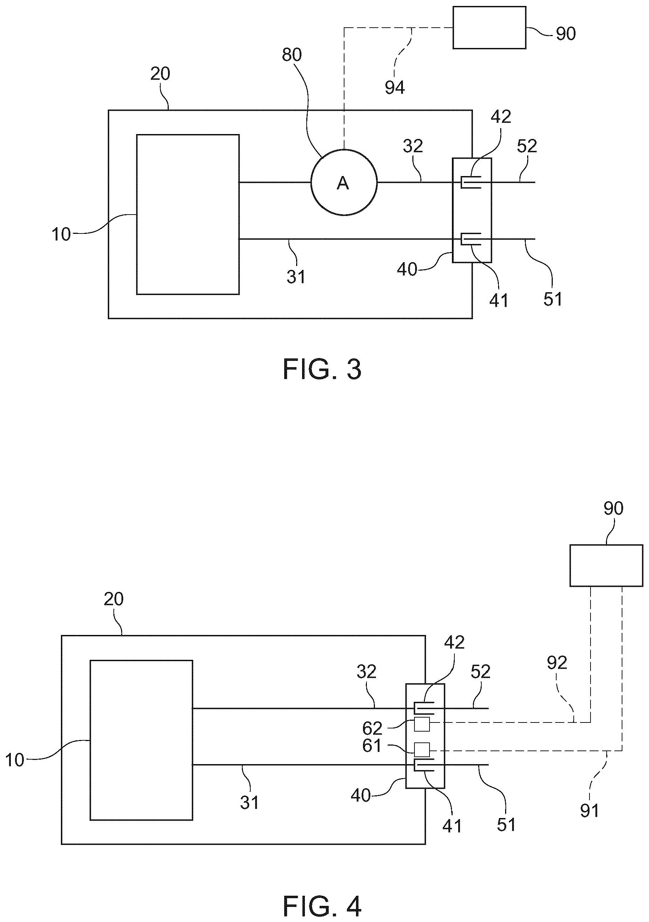

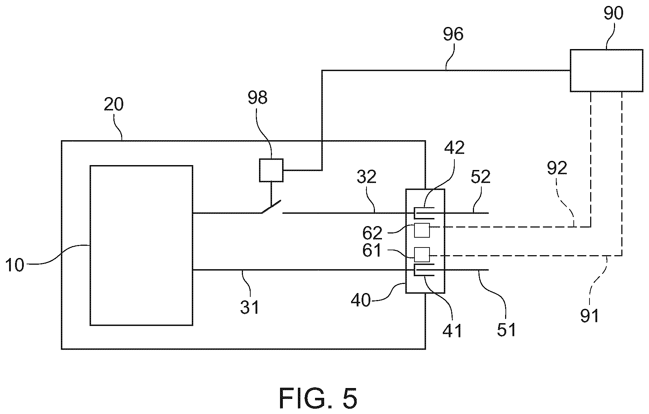

With the temperature measurement within the connector as introduced by the present invention, the main boundary conditions are no longer required for load estimation (see Figures 4 and 5 below). Based on the measured temperature, the load of the connector can be monitored. In urgent cases, countermeasures can be started, e. g., by a battery management unit (BMU) or a battery management system (BMS). In most cases, a more efficient connector system can thus be used in comparison to conventional connector systems (see Figures 1 to 3); hence a smaller - and thus cheaper - design for a connector system can be chosen when using a connector system according to the present invention.

This is reflected in Figure 1 by the line illustrating the behavior (i. e., the lifetime in dependence of an over-current) of the connector employed in an exemplary connector system according to the invention (connector II; see the legend of the diagram). As a fuse is no longer necessary, the connector (connector II) can be chosen less robust in comparison to the connector required in the conventional connector system (connector I), i. e., the lifetime of the connector employed in the connector system according to the invention (connector II) for a certain over-current may be reduced in comparison to the lifetime of the connector of the conventional system (connector I). Hence, the curve showing the behavior of the connector of the system according to the invention (connector II) runs below or on the curve illustrating the behavior of connector of the conventional system (connector I). Normally, a less robust connector is less expensive; accordingly, the manufacture costs required for a connector system will be reduced by the present invention.

The advantage is in particular present for the range of currents lower than a certain current c, in the diagram of Fig. 1 denoting the current, at which the line illustrating the behavior of the connector employed in the connector system according to the invention (connector II) intersects the curve of the fuse of the conventional connector system, as in this range, the curve runs in area A and the connector would thus not be protected by the fuse (see above).

Figure 2 shows a schematic illustration of a conventional connector system with a fuse 70, wherein the connector system is integrated in a battery system. The battery system may be adapted as a power source of a vehicle. A stack of battery cells 10 is accommodated within a housing 20. The stack of battery cells 10 has an anode (not shown) and a cathode (not shown). Integrated in the wall of the housing 20 is a connector 40 having a negative connection element 41 and a positive connection element 42. The negative connection element 41 is connected, via a first electrical connection line 31, with the anode of the stack of battery cells 10. Correspondingly, the positive connection element 42 is connected, via a second electrical connection line 32, with the cathode of the stack of battery cells 10. Integrated into the second connection line 32 is a fuse 70. The fuse 70 is adapted to interrupt the electrical connection via the second connection line 32 in case the current exceeds a predefined value. Instead of being integrated into the second connection line 32, the fuse could also be integrated into the first connection line 31 in alternative embodiments of conventional connector systems and/or battery systems.

In use, for example when implemented into a vehicle, the connector 40 is connected with a suitable counterpart (not shown) such that the negative connection element 41 is connected with a respective counterpart connection element 51 and the positive connection element 42 is connected with a respective counterpart connection element 52. Via the external counterparts 51, 52 of the negative and positive connection elements 41, 42, the electric current may then be transported to a load (not shown), for example, a motor.

The current at which the fuse 70 interrupts the conduction has to be adjusted to the maximum current being allowed to be transported through the connector 40 and thus, through each of the negative and positive connection elements 41, 42 of the connector 40. When adjusting the maximum fuse current to the connector 40, the tolerances of the fuse 70 as well as of the connector 40 have to be taken into account, i. e., for the sake of safety, the fuse 70 must be adapted to break the electrical connection at current smaller than the current, which could actually be transported by the connector 40.

During normal use, i. e., when the current conducted through the conductor 40 remains in a certain predefined range (i. e., in the range from 0 Ampère to the maximum fuse current), the fuse 70 lets the current pass through the second connection line 32. However, if the current at some point in time exceeds over a predefined threshold being defined by the maximum fuse current of the fuse 70 (i. e., in case of an overcurrent), the fuse 70 interrupts the electrical connection within the second connection line 32 such that the electric circuit with the load (not shown) and the stack of battery cells 10 is interrupted, or in other words, the stack of battery cells 10 is electrically disconnected from the load. Hence, the connector 40 is protected from overcurrent by fuse 70.

Fuses often exhibit the disadvantage of being single-use devices only. Thus, in the above-described assembly, the fuse 70 may be replaced by an amperemeter 80 connected to a control unit 90. This is shown in Figure 3. The amperemeter measures the current flowing through the second connection line 32, and a signal corresponding to the current (i. e., a current signal) is sent to the control unit 90. Then, the control unit 90 monitors - continuously or in sufficiently small time intervals - the strength of the current signal (which corresponds to the measured current) and checks whether or not the strength of the current signal exceeds over a predefined threshold that corresponds to the maximum current allowed to be transported through the connector 40. Once the current exceeds that predefined threshold, the control unit 90 triggers an electrical disconnection of the battery system from the load. This can be done, e. g., by a relay (not shown), which is implemented either within the battery system or connector system shown in Fig. 3 (i. e., in one of the first and second connection lines 31, 32) or outside of the battery system or connector system shown in Fig. 3 (e. g., in one of the counterparts 51, 52 of the connection elements 41, 42).

Similar to the example of Fig. 3, the current at which the control unit 90 interrupts the electric conduction (i. e., the threshold) has to be adjusted to the maximum current being allowed to be transported through the connector 40 and thus, through each of the negative and positive connection elements 41, 42 of the connector 40. When adjusting the threshold to the connector 40, the tolerances of the amperemeter 80 as well as of the connector 40 have to be taken into account, i. e., for the sake of safety, the threshold must be chosen such that control unit 90 breaks the electrical connection at current smaller than the current, which could actually be transported by the connector 40.

One embodiment of the connector system according to the invention being integrated into a battery system is shown in Figure 4. The basic set-up of the battery system is similar to that described above in the context of Figs. 2 and 3. A stack of battery cells 10 is accommodated within a housing 20. The stack of battery cells 10 has an anode (not shown) and a cathode (not shown). Integrated in the wall of the housing 20 is a connector 40 having a negative connection element 41 and a positive connection element 42. The negative connection element 41 is connected, via a first electrical connection line 31, with the anode of the stack of battery cells 10. Correspondingly, the positive connection element 42 is connected, via a second electrical connection line 32, with the cathode of the stack of battery cells 10.

However, in contrast to the assemblies shown in Figs. 2 and 3, there is neither a fuse nor an amperemeter integrated in one of the connection lines 31, 32. Instead, a first temperature sensor 61 is thermally connected to the negative connection element 41 and a second temperature sensor 62 is connected to the positive connection element 42. Each of the first and second temperature sensors 61, 62 may be a thermistor, for example a negative temperature coefficient thermistor (NTC thermistor) or a positive coefficient temperature thermistor (PTC thermistor), or a thermocouple. However, also other kinds of temperature sensors may be used. Preferably, the first and second temperature sensors 61, 62 are of the same type.

The first temperature sensor 61 measures the temperature of the negative connection element 41 and generates a corresponding first temperature signal encoding the measured temperature of the negative connection element 41. The first temperature signal is then transmitted to a control unit 90. Similarly, the second temperature sensor 62 measures the temperature of the positive connection element 42 and generates a corresponding second temperature signal encoding the measured temperature of the positive connection element 42. The second temperature signal is then also transmitted to the control unit 90. Each of the first and second temperature signal may be an electric signal (e. g., a voltage level) depending monotonously on the measured temperature. However, the temperature signal may also be a wireless signal, e. g., a near-field communication (NFC) signal or a WLAN signal or the like.

Then, the control unit 90 compares temperature signals received from the first and second temperature sensor 61, 62. The comparison can be performed using analog (non-digital) methods or using digital methods. The control unit generates a first value based on the first temperature signal and a second value based on the second temperature signal. In particular when using an analog method for the comparison and if the types of the first and second temperature sensor 61, 62 are identical, the first value may directly be the strength of the first temperature signal and the second value may directly be the strength of the second temperature signal. If the types of the sensors are not identical, at least one of the first and second temperature signals may be transformed such that first value and second value yield temperature values in the same temperature scale. The first and second values may correspond to the temperature in a standardized temperature scale (e. g., correspond to units in °C). However, the first and second values may correspond to any other temperature scale, which may be linear or non-linear. It is preferred that first and second value encode or correspond to the measured temperature in the same scale.

Instead of values corresponding to the absolute temperature measured by the first and second temperature sensors 61, 62, relative values may be used for the comparison. For example, the measured temperatures (in a certain temperature scale) may be divided by the measured temperature (in the same scale) of the negative connection element 41 or divided by the measured temperature of the positive connection element 42 or divided by a mean value (e. g., the arithmetic mean) of the temperatures of the first and second connection elements 41, 42.

The comparison may be performed by calculating the difference between the first value (based on the first temperature signal) and the second value (based on the second temperature signal). Then, if the absolute value of the difference exceeds a predefined value, the control unit 90 generates an alert signal. The alert signal may be provided at an output of the control unit. The alert signal may be an electric signal (e. g., a voltage level) and/or a wireless signal, e. g., a near-field communication (NFC) signal or a WLAN signal or the like.

If the absolute value of the difference between the first value and the second value exceeds over a predefined threshold, the probability that a contact resistance between one of the connection elements 41, 42 and its respective counterpart connection element 51, 52 (the latter not being part of the invention) is increased, which in turn may indicate a connection failure.

Additionally, also the absolute temperatures measured at the negative and/or positive connection element 41, 42 may be supervised by the control unit 90. Then the control unit 90 may also output an alert signal indicating that the maximum allowed temperature of one of the connection elements 41, 42 has been exceeded.

The alert signal may be configured such that it directly suitable to control a relay 98 as shown in Figure 5. In the example shown in the figure, the relay 98 is implemented into the second connection line 32 between the positive connection element 42 and the cathode of the stack of battery cells 10. However, the relay 98 could alternatively also be implemented into the first connection line 31. The control unit 90 is connected, via a signal line 96, to the relay 98 and operates the relay 98 such that the relay 98 interrupts the second connection line 32 upon receiving a respective signal (a current) from the control unit 90. Instead of being integrated into one of the connection lines 31, 32 connection the connection elements 41, 42 with the stack of battery cells 10, the relay 98 could also be positioned outside the battery system (e. g., connected to the counterpart element 52 of the positive connection element 42) at some position in the circuit being powered by the battery system that allows for disconnecting the battery system from the load. Alternatively, the alert signal can also be transmitted to the load itself or a further control unit controlling the load (not shown) such that the load is shut down in response to receiving the alert signal.

Alternatively, the alert signal could also be transmitted from the control unit 90 to a battery management unit (BMU; not shown in the figures) of the battery system. Then, the BMU may control the operations upon receiving the alert signal from the control unit 90. For example, the BMU may be configured to control a relay so as to interrupt the circuit powered by the battery system or may be configured to shut down the load driven by the battery system. In embodiments, the control unit 90 may be integrated within the BMU.

### Reference signs

- 10: stack of battery cells
- 20: housing of a battery system
- 31: connection between the negative connection element and the anode of the stack of battery cells
- 32: connection between the positive connection element and the cathode of the stack of battery cells
- 40: connector
- 41: negative connection element
- 42: positive connection element
- 51: counterpart of negative connection element
- 52: counterpart of positive connection element
- 61: first temperature sensor
- 62: second temperature sensor
- 70: fuse
- 80: amperemeter
- 90: control unit
- 91: signal line between first temperature element and control unit
- 92: signal line between second temperature element and control unit
- 94: signal line between amperemeter and control unit
- 96: signal line between control unit and relay
- 98: relay

## Claims

1. A connector system for establishing an electric connection with a battery system, the connector system comprising:
a connector (40) for establishing an electrically conductive connection to a suitable counterpart of the connector, wherein the connector (40) comprises a negative connection element (41) and a positive connection element (42);
a first temperature sensor (61) thermally connected to the negative connection element (41);
a second temperature sensor (62) thermally connected to the positive connection element (42); and
a control unit (90) configured for receiving a first temperature signal from the first temperature sensor (61) and for receiving a second temperature signal from the second temperature sensor (62);
wherein the control unit (90) is adapted for generating a first value based on the first temperature signal and a second value based on the second temperature signal,
wherein the control unit (90) is further adapted for generating a first alert signal when the absolute value of a difference between the first value and the second value exceeds over a predefined threshold,
wherein the negative connection element (41) is electrically connected with an anode of a stack of battery cells of the battery system via a first electrical connection line (31), and the positive connection element (42) is electrically connected with a cathode of the stack of battery cells via a second electrical connection line (32),
wherein the control unit (90) is further configured to output a second alert signal based on at least one of the first value and the second value, and
wherein the second alert signal is a signal suitable for directly controlling a relay (98) implemented into one of the first electrical connection line (31) and the second electrical connection line (32).

2. The connector system according to claim 1, wherein the predefined threshold depends on the first temperature signal or on the second temperature signal or on a mean value of the first and second temperature signal.

3. The connector system according to claim 1 or 2,
wherein the connector (40) is formed as a socket being connectable with a suitable plug; or
wherein the connector (40) is formed as a plug being connectable with a suitable socket.

4. The connector system according to any one of claims 1 to 3, wherein the negative connection element (41) and the positive connection element (42) are each configured for establishing a high voltage connection.

5. The connector system according to any one of claims 1 to 4, wherein at least one of the temperature sensors (61, 62) is a thermistor, for example a negative temperature coefficient thermistor or a positive coefficient temperature thermistor, or a thermocouple.

6. The connector system according to any one of claims 1 to 5, wherein the control unit (90) is further adapted for generating the second alert signal in case the first value or the second value indicates that the absolute temperature of the negative connection element (41) or the positive connection element (42) exceeds a predefined maximum value.

7. The connector system according to any one of claims 1 to 6, wherein the connector (40) is integrated in a housing (20) adapted for accommodating a stack of battery cells (10).

8. A battery system comprising a stack of battery cells (10) and the connector system according to claim 7, wherein the stack of battery cells (10) is accommodated in the housing (20), and wherein the negative connection element (41) is electrically connected with the anode of the stack of battery cells (10) and the positive connection element (42) is electrically connected with the cathode of the stack of battery cells (10).

9. A battery system comprising a stack of battery cells (10) and the connector system according to any one of claims 1 to 6, wherein the negative connection element (41) is electrically connected with the anode of the stack of battery cells (10) and the positive connection element (42) is electrically connected with the cathode of the stack of battery cells (10).

10. The battery system according to claim 8 or 9, wherein the battery system further comprises a battery management unit, and wherein the control unit (90) is integrated into the battery management unit.

11. A battery module comprising two or more battery systems according to any one of claims 8 to 10.

12. A vehicle comprising the battery system according to any one of claims 8 to 10 or the battery module according to claim 11.

13. A method for controlling an electrically conductive connection to a battery system using the connector system according to any one of claims 1 to 7, the method comprising the following steps:
measuring, by a first temperature sensor (61), the temperature of a negative connection element (41) and generating a first temperature signal based on the measured temperature of the negative connection element (41);
sending the first temperature signal to a control unit (90);
measuring, by a second temperature sensor (62), the temperature of a positive connection element (42) and generating a second temperature signal based on the measured temperature of the positive connection element (42);
sending the second temperature signal to the control unit (90);
generating, by the control unit (90), a first value based on the first temperature signal and a second value based on the second temperature signal;
computing, by the control unit (90), the difference of the first value and the second value; and
generating, by the control unit (90), a first alert signal when the absolute value of said difference exceeds a predefined threshold,
wherein the method is further comprising outputting, by the control unit (90), a second alert signal based on at least one of the first value and the second value,
wherein the negative connection element (41) is electrically connected with an anode of a stack of battery cells of the battery system via a first electrical connection line (31), and the positive connection element (42) is electrically connected with a cathode of the stack of battery cells via a second electrical connection line (32), and
wherein the second alert signal is a signal suitable for directly controlling a relay (98) implemented into one of the first electrical connection line (31) and the second electrical connection line (32).

14. The method according to claim 13, wherein each of the steps is performed or repeated continuously in time.

15. The method according to claim 13, wherein each of the steps is repeated after a predefined time interval.

## Patentansprüche

1. Verbindersystem zum Herstellen einer elektrischen Verbindung mit einem Batteriesystem, wobei das Verbindersystem Folgendes umfasst:
einen Verbinder (40) zum Herstellen einer elektrisch leitenden Verbindung mit einem geeigneten Gegenstück des Verbinders, wobei der Verbinder (40) ein negatives Verbindungselement (41) und ein positives Verbindungselement (42) umfasst;
einen ersten Temperatursensor (61), der thermisch mit dem negativen Verbindungselement (41) verbunden ist;
einen zweiten Temperatursensor (62), der thermisch mit dem positiven Verbindungselement (42) verbunden ist; und
eine Steuereinheit (90), die dazu konfiguriert ist, ein erstes Temperatursignal vom ersten Temperatursensor (61) und ein zweites Temperatursignal vom zweiten Temperatursensor (62) zu empfangen;
wobei die Steuereinheit (90) dazu ausgelegt ist, einen ersten Wert auf der Grundlage des ersten Temperatursignals und einen zweiten Wert auf der Grundlage des zweiten Temperatursignals zu erzeugen,
wobei die Steuereinheit (90) ferner dazu ausgelegt ist, ein erstes Warnsignal zu erzeugen, wenn der Absolutwert einer Differenz zwischen dem ersten Wert und dem zweiten Wert einen vordefinierten Schwellenwert überschreitet,
wobei das negative Verbindungselement (41) über eine erste elektrische Verbindungsleitung (31) mit einer Anode eines Stapels von Batteriezellen des Batteriesystems und das positive Verbindungselement (42) über eine zweite elektrische Verbindungsleitung (32) mit einer Kathode des Stapels von Batteriezellen elektrisch verbunden ist,
wobei die Steuereinheit (90) ferner dazu konfiguriert ist, ein zweites Warnsignal auf der Grundlage mindestens eines von dem ersten Wert und dem zweiten Wert auszugeben, und
wobei das zweite Warnsignal ein Signal ist, das zur direkten Ansteuerung eines Relais (98) geeignet ist, das in einer von der ersten elektrischen Verbindungsleitung (31) und der zweiten elektrischen Verbindungsleitung (32) implementiert ist.

2. Verbindersystem nach Anspruch 1, wobei der vordefinierte Schwellenwert vom ersten Temperatursignal oder vom zweiten Temperatursignal oder von einem Mittelwert des ersten und des zweiten Temperatursignals abhängt.

3. Verbindersystem nach Anspruch 1 oder 2,
wobei der Verbinder (40) als Buchse ausgebildet ist, die mit einem geeigneten Stecker verbindbar ist; oder
wobei der Verbinder (40) als Stecker ausgebildet ist, der mit einer geeigneten Buchse verbindbar ist.

4. Verbindersystem nach einem der Ansprüche 1 bis 3, wobei das negative Verbindungselement (41) und das positive Verbindungselement (42) jeweils zum Herstellen einer Hochspannungsverbindung konfiguriert sind.

5. Verbindersystem nach einem der Ansprüche 1 bis 4, wobei mindestens einer der Temperatursensoren (61, 62) ein Thermistor, beispielsweise ein Thermistor mit negativem Temperaturkoeffizienten oder ein Thermistor mit positivem Temperaturkoeffizienten, oder ein Thermoelement ist.

6. Verbindersystem nach einem der Ansprüche 1 bis 5, wobei die Steuereinheit (90) ferner dazu ausgelegt ist, das zweite Warnsignal zu erzeugen, falls der erste Wert oder der zweite Wert angibt, dass die absolute Temperatur des negativen Verbindungselements (41) oder des positiven Verbindungselements (42) einen vordefinierten Maximalwert überschreitet.

7. Verbindersystem nach einem der Ansprüche 1 bis 6, wobei der Verbinder (40) in ein Gehäuse (20) integriert ist, das zur Aufnahme eines Stapels von Batteriezellen (10) ausgelegt ist.

8. Batteriesystem, umfassend einen Stapel von Batteriezellen (10) und das Verbindersystem nach Anspruch 7, wobei der Stapel von Batteriezellen (10) in dem Gehäuse (20) aufgenommen ist, und wobei das negative Verbindungselement (41) mit der Anode des Stapels von Batteriezellen (10) und das positive Verbindungselement (42) mit der Kathode des Stapels von Batteriezellen (10) elektrisch verbunden ist.

9. Batteriesystem, umfassend einen Stapel von Batteriezellen (10) und das Verbindersystem nach einem der Ansprüche 1 bis 6, wobei das negative Verbindungselement (41) mit der Anode des Stapels von Batteriezellen (10) und das positive Verbindungselement (42) mit der Kathode des Stapels von Batteriezellen (10) elektrisch verbunden ist.

10. Batteriesystem nach Anspruch 8 oder 9, wobei das Batteriesystem ferner eine Batteriemanagementeinheit umfasst, und wobei die Steuereinheit (90) in die Batteriemanagementeinheit integriert ist.

11. Batteriemodul, umfassend zwei oder mehr Batteriesysteme nach einem der Ansprüche 8 bis 10.

12. Fahrzeug, umfassend das Batteriesystem nach einem der Ansprüche 8 bis 10 oder das Batteriemodul nach Anspruch 11.

13. Verfahren zur Steuerung einer elektrisch leitenden Verbindung zu einem Batteriesystem unter Verwendung des Verbindersystems nach einem der Ansprüche 1 bis 7, wobei das Verfahren die folgenden Schritte umfasst:
Messen der Temperatur eines negativen Verbindungselements (41) mittels eines ersten Temperatursensors (61) und Erzeugen eines ersten Temperatursignals auf der Grundlage der gemessenen Temperatur des negativen Verbindungselements (41);
Senden des ersten Temperatursignals an eine Steuereinheit (90);
Messen der Temperatur eines positiven Verbindungselements (42) mittels eines zweiten Temperatursensors (62) und Erzeugen eines zweiten Temperatursignals auf der Grundlage der gemessenen Temperatur des positiven Verbindungselements (42);
Senden des zweiten Temperatursignals an die Steuereinheit (90);
Erzeugen eines ersten Wertes auf der Grundlage des ersten Temperatursignals und eines zweiten Wertes auf der Grundlage des zweiten Temperatursignals durch die Steuereinheit (90);
Berechnen der Differenz zwischen dem ersten Wert und dem zweiten Wert durch die Steuereinheit (90); und
Erzeugen eines ersten Warnsignals durch die Steuereinheit (90), wenn der Absolutwert der besagten Differenz einen vordefinierten Schwellenwert überschreitet,
wobei das Verfahren ferner das Ausgeben eines zweiten Alarmsignals durch die Steuereinheit (90) auf der Grundlage mindestens eines von dem ersten Wert und dem zweiten Wert umfasst,
wobei das negative Verbindungselement (41) über eine erste elektrische Verbindungsleitung (31) mit einer Anode eines Stapels von Batteriezellen des Batteriesystems und das positive Verbindungselement (42) über eine zweite elektrische Verbindungsleitung (32) mit einer Kathode des Stapels von Batteriezellen elektrisch verbunden ist, und
wobei das zweite Warnsignal ein Signal ist, das zur direkten Steuerung eines Relais (98) geeignet ist, das in einer von der ersten elektrischen Verbindungsleitung (31) und der zweiten elektrischen Verbindungsleitung (32) implementiert ist.

14. Verfahren nach Anspruch 13, wobei jeder der Schritte zeitlich kontinuierlich durchgeführt oder wiederholt wird.

15. Verfahren nach Anspruch 13, wobei jeder der Schritte nach einem vordefinierten Zeitintervall wiederholt wird.

## Revendications

1. Système de connecteur pour établir une connexion électrique avec un système de batterie, le système de connecteur comportant :
un connecteur (40) pour établir une connexion électriquement conductrice à un homologue approprié du connecteur, dans lequel le connecteur (40) comporte un élément de connexion négatif (41) et un élément de connexion positif (42) ;
un premier capteur de température (61) relié thermiquement à l'élément de connexion négatif (41) ;
un deuxième capteur de température (62) relié thermiquement à l'élément de connexion positif (42) ; et
une unité de commande (90) configurée pour recevoir un premier signal de température provenant du premier capteur de température (61) et pour recevoir un deuxième signal de température provenant du deuxième capteur de température (62) ;
dans lequel l'unité de commande (90) est adaptée pour générer une première valeur sur la base du premier signal de température et une deuxième valeur sur la base du deuxième signal de température,
dans lequel l'unité de commande (90) est en outre adaptée pour générer un premier signal d'alerte lorsque la valeur absolue d'une différence entre la première valeur et la deuxième valeur dépasse un seuil prédéfini,
dans lequel l'élément de connexion négatif (41) est connecté électriquement à une anode d'un empilement de cellules de batterie du système de batterie via une première ligne de connexion électrique (31), et l'élément de connexion positif (42) est connecté électriquement à une cathode de l'empilement de cellules de batterie via une deuxième ligne de connexion électrique (32),
dans lequel l'unité de commande (90) est en outre configurée pour émettre un deuxième signal d'alerte sur la base d'au moins l'une de la première valeur et de la deuxième valeur, et
dans lequel le deuxième signal d'alerte est un signal adapté pour commander directement un relais (98) mis en œuvre dans l'une de la première ligne de connexion électrique (31) et de la deuxième ligne de connexion électrique (32).

2. Système de connecteur selon la revendication 1, dans lequel le seuil prédéfini dépend du premier signal de température ou du deuxième signal de température ou d'une valeur moyenne du premier et du deuxième signal de température.

3. Système de connecteur selon la revendication 1 ou 2,
dans lequel le connecteur (40) se présente sous la forme d'une prise pouvant être connectée à une fiche appropriée ; ou
dans lequel le connecteur (40) se présente sous la forme d'une fiche pouvant être connectée à une prise appropriée.

4. Système de connecteur selon l'une quelconque des revendications 1 à 3, dans lequel l'élément de connexion négatif (41) et l'élément de connexion positif (42) sont chacun configurés pour établir une connexion haute tension.

5. Système de connecteur selon l'une quelconque des revendications 1 à 4, dans lequel au moins l'un des capteurs de température (61, 62) est une thermistance, par exemple une thermistance à coefficient de température négatif ou une thermistance à coefficient de température positif, ou un thermocouple.

6. Système de connecteur selon l'une quelconque des revendications 1 à 5, dans lequel l'unité de commande (90) est en outre adaptée pour générer le deuxième signal d'alerte dans le cas où la première valeur ou la deuxième valeur indique que la température absolue de l'élément de connexion négatif (41) ou de l'élément de connexion positif (42) dépasse une valeur maximale prédéfinie.

7. Système de connecteur selon l'une quelconque des revendications 1 à 6, dans lequel le connecteur (40) est intégré dans un boîtier (20) adapté pour loger un empilement de cellules de batterie (10).

8. Système de batterie comportant un empilement de cellules de batterie (10) et le système de connecteur selon la revendication 7, dans lequel l'empilement de cellules de batterie (10) est logé dans le boîtier (20), et dans lequel l'élément de connexion négatif (41) est connecté électriquement à l'anode de l'empilement de cellules de batterie (10) et l'élément de connexion positif (42) est connecté électriquement à la cathode de l'empilement de cellules de batterie (10).

9. Système de batterie comportant un empilement de cellules de batterie (10) et le système de connecteur selon l'une quelconque des revendications 1 à 6, dans lequel l'élément de connexion négatif (41) est connecté électriquement à l'anode de l'empilement de cellules de batterie (10) et l'élément de connexion positif (42) est connecté électriquement à la cathode de l'empilement de cellules de batterie (10).

10. Système de batterie selon la revendication 8 ou 9, dans lequel le système de batterie comporte en outre une unité de gestion de batterie, et dans lequel l'unité de commande (90) est intégrée dans l'unité de gestion de batterie.

11. Module de batterie comportant deux systèmes de batterie ou plus selon l'une quelconque des revendications 8 à 10.

12. Véhicule comportant le système de batterie selon l'une quelconque des revendications 8 à 10 ou le module de batterie selon la revendication 11.

13. Procédé de commande d'une connexion électriquement conductrice à un système de batterie utilisant le système de connecteur selon l'une quelconque des revendications 1 à 7, le procédé comportant les étapes suivantes :
la mesure, au moyen d'un premier capteur de température (61), de la température d'un élément de connexion négatif (41) et la génération d'un premier signal de température sur la base de la température mesurée de l'élément de connexion négatif (41) ;
l'envoi du premier signal de température à une unité de commande (90) ;
la mesure, au moyen d'un deuxième capteur de température (62), de la température d'un élément de connexion positif (42) et la génération d'un deuxième signal de température sur la base de la température mesurée de l'élément de connexion positif (42) ;
l'envoi du deuxième signal de température à l'unité de commande (90) ;
la génération, au moyen de l'unité de commande (90), d'une première valeur sur la base du premier signal de température et d'une deuxième valeur sur la base du deuxième signal de température ;
le calcul, au moyen de l'unité de commande (90), de la différence entre la première valeur et la deuxième valeur ; et
la génération, au moyen de l'unité de commande (90), d'un premier signal d'alerte lorsque la valeur absolue de ladite différence dépasse un seuil prédéfini,
dans lequel le procédé comporte en outre l'émission, au moyen de l'unité de commande (90), d'un deuxième signal d'alerte sur la base d'au moins l'une de la première valeur et de la deuxième valeur,
dans lequel l'élément de connexion négatif (41) est connecté électriquement à une anode d'un empilement de cellules de batterie du système de batterie via une première ligne de connexion électrique (31), et l'élément de connexion positif (42) est connecté électriquement à une cathode de l'empilement de cellules de batterie via une deuxième ligne de connexion électrique (32), et
dans lequel le deuxième signal d'alerte est un signal adapté pour commander directement un relais (98) mis en œuvre dans l'une de la première ligne de connexion électrique (31) et de la deuxième ligne de connexion électrique (32).

14. Procédé selon la revendication 13, dans lequel chacune des étapes est réalisée ou répétée en continu dans le temps.

15. Procédé selon la revendication 13, dans lequel chacune des étapes est répétée après un intervalle de temps prédéfini.
